(19)

Europäisches
Patentamt
European
Patent Office
Office européen
des brevets

(11)  **EP 4 362 301 A1**

(12)  **EUROPEAN PATENT APPLICATION**

(43) Date of publication:
**01.05.2024  Bulletin 2024/18**

(21) Application number: **23186079.2**

(22) Date of filing: **18.07.2023**

(51) International Patent Classification (IPC):
**H02M 1/00** (2006.01)       **H02M 3/158** (2006.01)
**H02M 1/14** (2006.01)

(52) Cooperative Patent Classification (CPC):
**H02M 1/0032; H02M 3/158;** H02M 1/14;
H03K 3/0231; H03K 7/08

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **27.10.2022  KR 20220140680**

(71) Applicant: **Samsung Electronics Co., Ltd.
Suwon-si, Gyeonggi-do 16677 (KR)**

(72) Inventors:
• **CHO, Sungkyu
Suwon-si (KR)**

• **YOON, Kyeseok
Suwon-si (KR)**
• **KIM, Dongjoon
Suwon-si (KR)**
• **LEE, Sungwoo
Suwon-si (KR)**
• **CHO, Daewoong
Suwon-si (KR)**
• **HEO, Jungwook
Suwon-si (KR)**

(74) Representative: **Marks & Clerk LLP
15 Fetter Lane
London EC4A 1BW (GB)**

(54)   **VOLTAGE CONVERTER AND POWER SUPPLY INCLUDING THE SAME**

(57)    A voltage converter, including a switch circuit configured to generate an output voltage by switching an input voltage and a ground voltage based on a driving control signal; an error voltage generator configured to generate an error voltage based on a comparison between the output voltage and a reference voltage; a duty signal generator configured to generate a duty signal having a constant pulse frequency or a modulated pulse frequency, based on a result of the comparing; and a driving controller configured to generate the driving control signal based on the duty signal.

FIG. 2

EP 4 362 301 A1

# Description

BACKGROUND

1. Field

The disclosure relates to a voltage converter and a power supply including the same.

2. Description of the Related Art

An electronic device may include a power supply which converts a voltage provided from an outside of the power supply in order to supply a power voltage to internal elements thereof, or which converts a voltage provided from a built-in battery to supply the converted voltage to the outside. The power supply may include a voltage converter, and particularly, a direct current to direct current (DC-DC) converter having a relatively small size and high efficiency in order to efficiently supply a stable power voltage. DC-DC converters may be configured to generate a direct current (DC) output voltage by using various methods according to load conditions.

SUMMARY

Provided is a voltage converter configured to generate a DC output voltage in a pulse frequency modulation (PFM) method under a light load condition.

Also provided is a voltage converter that supplies a low ripple and stable DC output voltage and current.

Also provided is a voltage converter that reduces switching loss.

Additional aspects will be set forth in part in the description which follows and, in part, will be apparent from the description, or may be learned by practice of the presented embodiments.

In accordance with an aspect of the disclosure, a voltage converter includes a switch circuit configured to generate an output voltage by switching an input voltage and a ground voltage based on a driving control signal; an error voltage generator configured to generate an error voltage based on a comparison between the output voltage and a reference voltage; a duty signal generator configured to generate a duty signal having a constant pulse frequency or a modulated pulse frequency, based on a result of the comparing; and a driving controller configured to generate the driving control signal based on the duty signal.

In accordance with an aspect of the disclosure, a power supply includes a conversion circuit including a plurality of driving elements configured to convert an input voltage into an output voltage by switching based on a driving control signal, wherein the conversion circuit is configured to output the output voltage to a load; and a charging controller configured to adjust a period of the driving control signal and a duty cycle of the driving control signal under a light load condition.

In accordance with an aspect of the disclosure, a power system includes a switch circuit including: a first driving element configured to connect a first node and a switching node based on a first driving control signal, a second driving element configured to connect a ground voltage and the switching node based on a second driving control signal, and an inductor connected between the switching node and a second node; and a charging controller configured to: generate an error voltage based on a smaller of a difference between a voltage of the first node and a first reference voltage, and a difference between a voltage of the switching node and a second reference voltage, decrease a period of the first driving control signal and a period of the second driving control signal based on the error voltage increasing, and increase a duty cycle of the first driving control signal and a duty cycle of the second driving control signal based on the error voltage increasing.

At least some of the above and other features of the invention are set out in the claims.

BRIEF DESCRIPTION OF DRAWINGS

FIG. 1 illustrates a block diagram of a power supply system according to an embodiment.

FIG. 2 illustrates a block diagram of a power supply according to an embodiment.

FIG. 3 illustrates a block diagram of a voltage converter according to an embodiment.

FIG. 4 illustrates a detailed circuit diagram of an error voltage generator according to an embodiment.

FIG. 5 illustrates a detailed circuit diagram of an oscillator according to an embodiment.

FIG. 6 illustrates a detailed circuit diagram of a ramp generator according to an embodiment.

FIG. 7 illustrates a timing diagram of several signals of a voltage supply device according to an embodiment.

FIG. 8, FIG. 9, and FIG. 10 illustrate waveform diagrams of an inductor current and an output voltage of a voltage converter according to an embodiment.

FIG. 11 illustrates a graph of efficiency of a voltage converter according to an embodiment.

FIG. 12 and FIG. 13 illustrate waveform diagrams of an output current and an output voltage of a voltage converter according to an embodiment.

FIG. 14 and FIG. 15 illustrate waveform diagrams of an input voltage and an output voltage of a voltage converter according to an embodiment.

FIG. 16 illustrates a block diagram of a power system of a mobile device according to an embodiment.

FIG. 17 illustrates a block diagram of a mobile device according to an embodiment.

## DETAILED DESCRIPTION

Embodiments are described more fully hereinafter with reference to the accompanying drawings. Those skilled in the art will understand that the described embodiments may be modified in various different ways, all without departing from the scope of the disclosure.

Accordingly, the drawings and description are to be regarded as illustrative in nature and not restrictive. Like reference numerals designate like elements throughout the description. In the flowcharts described with reference to the drawings in this description, the operation order may be changed, various operations may be merged, certain operations may be divided, and certain operations may not be performed.

In addition, a singular form may be intended to include a plural form as well, unless the explicit expression such as "one" or "single" is used. Terms including ordinal numbers such as first, second, and the like are used only to describe various elements, and are not to be interpreted as limiting these elements. These terms may be used for a purpose of distinguishing one element from other elements.

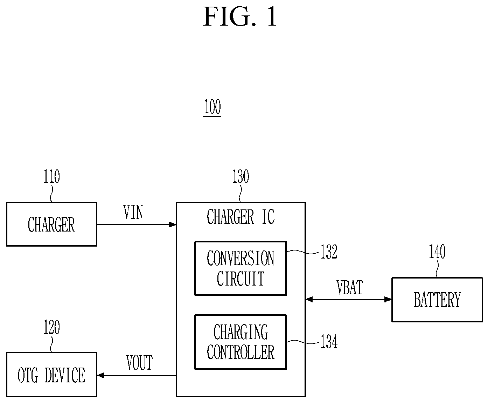

FIG. 1 illustrates a block diagram of a power supply system according to an embodiment.

Referring to FIG. 1, a power supply system 100 may include a charger 110, an on-the-go (OTG) device 120, a charging integrated circuit 130 (illustrated as "CHARGING IC"), and a battery 140.

The charger 110 may convert power provided from household power, for example alternating current (AC) 110 V to 220 V, or other power supply device, for example, an electronic device such as a computer, a TV, and the like, into direct current (DC) power used to charge the battery 140.

The charging integrated circuit 130 may be connected to the charger 110 or the OTG device 120. The charging integrated circuit 130 may be connected to the charger 110 to form a charging path for charging the battery 140. The charging integrated circuit 130 may be connected to the OTG device 120 to form a charging path for charging the OTG device 120.

The charging integrated circuit 130 may include a conversion circuit 132 and a charging controller 134. The conversion circuit 132 may convert the input voltage in order to output it to a load. For example, the conversion circuit 132 may receive an input voltage VIN, and may output a converted voltage VBAT to the battery 140 through a switching operation. The conversion circuit 132 may provide an output voltage VOUT to the OTG device 120 by boosting the voltage VBAT of the battery 140. For example, the conversion circuit 132 may be or include at least one buck converter that generates a target output voltage VBAT that is lower than the input voltage VIN, or at least one boost converter that generates a target output voltage VOUT that is higher than the input voltage VBAT. The conversion circuit 132 may be a switching mode power supply (SMPS) or a power converter.

The charging controller 134 may control a switching operation of the conversion circuit 132 based on a duty signal. In an embodiment, the charging controller 134 may adjust a period of the duty signal by using a pulse frequency modulation (PFM) method under a light load condition in which a current flowing through a load is small. In some embodiments, the charging controller 134 may generate an error voltage according to several control factors, such as an output voltage, an input voltage, an output current, and an input current of the conversion circuit 132, a current flowing through the battery 140, and a voltage of the battery 140. The charging controller 134 may change the period of the duty signal based on a voltage difference between the error voltage and a reference voltage. In an embodiment, the charging controller 134 may change a duty cycle of the duty signal under the light load condition. In some embodiments, the charging controller 134 may change the duty cycle of the duty signal by comparing the error voltage and a ramp signal. The charging controller 134 may adjust the duty cycle by adjusting a slope of the ramp signal. The charging controller 134 may generate a stable output voltage by operating the conversion circuit 132 based on a duty signal having a constant period under the light load condition. In addition, the charging controller 134 may improve a ripple of the output voltage by changing the duty cycle of the duty signal.

In embodiments, the charging integrated circuit 130 may include an undervoltage lockout (UVLO) function, an overcurrent protection (OCP) function, an overvoltage protection (OVP) function, an internal soft-start function for reducing an inrush current, a foldback current limit function, a hiccup mode function for short circuit protection, and an overtemperature protection (OTP) function, even under a power saving condition. The charging integrated circuit 130 may include an open-drain power good (PG) pin.

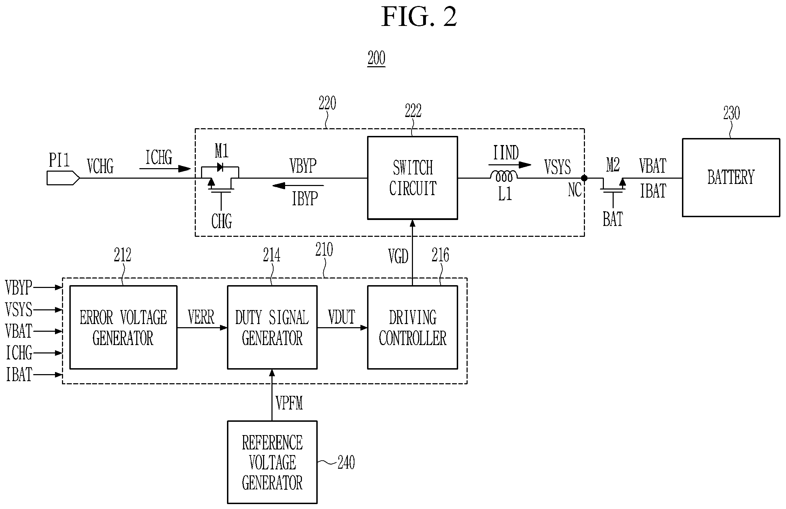

FIG. 2 illustrates a block diagram of a power supply according to an embodiment.

Referring to FIG. 2, a power supply 200 may be connected between an input/output pin PI1 and a battery 230. The power supply 200 may convert an input voltage VIN provided to the input/output pin PI1 to provide it to the battery 230. The power supply 200 may output an output voltage VOUT and may convert a voltage from the battery 230 to the input/output pin PI1. The power supply 200 may include a charging controller 210 and a conversion circuit 220.

The conversion circuit 220 may include a first transistor M1, a switch circuit 222, and an inductor L1. The first transistor M1 is connected between the input/output pin PI1 and the switch circuit 222, and may operate based on a control signal CHG provided from outside, for example from outside of the conversion circuit 220 or outside of the power supply 200.

The switch circuit 222 may store energy from an input voltage VCHG in the inductor L1 or discharge energy stored in the inductor L1 in response to a driving control signal VGD provided from the charging controller 210. For example, when the driving control signal VGD having a logic high level is input, the switch circuit 222 may store energy in the inductor L1 by flowing a current by the input voltage VCHG into the inductor L1. When the driving control signal VGD having a logic low level is input, the switch circuit 222 may discharge energy stored in the inductor L1. The energy discharged from the inductor L1 may be supplied to a load as a current.

A second transistor M2 may transmit a system voltage VSYS of a charging node NC to the battery 230 in response to a control signal BAT. Here, the system voltage VSYS may be a target output voltage of the power supply 200.

The charging controller 210 may receive control factors such as a bypass voltage VBYP, an input current ICHG, a system voltage VSYS, a battery voltage VBAT, a battery current IBAT, and temperature information, and may generate the driving control signal VGD for controlling the switch circuit 222. The charging controller 210 may adjust a period and a duty cycle of the driving control signal VGD under the light load condition. The charging controller 210 may include an error voltage generator 212, a duty signal generator 214, and a driving controller 216.

The error voltage generator 212 may generate an error voltage VERR by feeding back values of a plurality of signals input to and output from the conversion circuit 220. In an embodiment, the error voltage generator 212 may generate the error voltage VERR by respectively comparing several control factors with reference values of the several control factors. The error voltage generator 212 may generate the error voltage VERR based on a control factor having a minimum difference from the corresponding reference value among several control factors. For example, when the bypass voltage VBYP, the input current ICHG, the system voltage VSYS, the battery voltage VBAT, and the battery current IBAT are provided as control factors, the error voltage generator 212 may compare respective control factors with corresponding reference values. Even if each of the bypass voltage VBYP, the input current ICHG, the system voltage VSYS, and the battery voltage VBAT has a large difference from the corresponding reference value, when the difference between the battery current IBAT and the corresponding reference value is small, the error voltage generator 212 may generate the error voltage VERR based on the difference between the battery current IBAT and the corresponding reference value. A value of the error voltage VERR may be adjusted based on a difference between the battery current IBAT and the corresponding reference value. The error voltage VERR may be used to determine whether the duty signal generator 214 is active.

The duty signal generator 214 may generate a duty signal VDUT by comparing the error voltage VERR with a reference voltage VPFM. When the error voltage VERR is greater than the reference voltage VPFM, the duty signal generator 214 may generate the duty signal VDUT by using a pulse width modulation (PWM) method. When the error voltage VERR is equal to or smaller than the reference voltage VPFM, the duty signal generator 214 may generate the duty signal VDUT by the PFM method. The duty signal generator 214 may be deactivated when a level of the error voltage VERR is at a ground voltage.

The driving controller 216 may generate the driving control signal VGD based on the duty signal VDUT. The driving controller 216 may generate the driving control signal VGD having a logic high level based on the duty signal VDUT having a logic high level, and may generate the driving control signal VGD having a logic low level based on the duty signal VDUT having a logic low level.

A reference voltage generator 240 may generate the reference voltage VPFM to provide it to the charging controller 210. In addition, the reference voltage generator 240 may provide reference values corresponding to several control factors provided to the error voltage generator 212 in a form of a voltage.

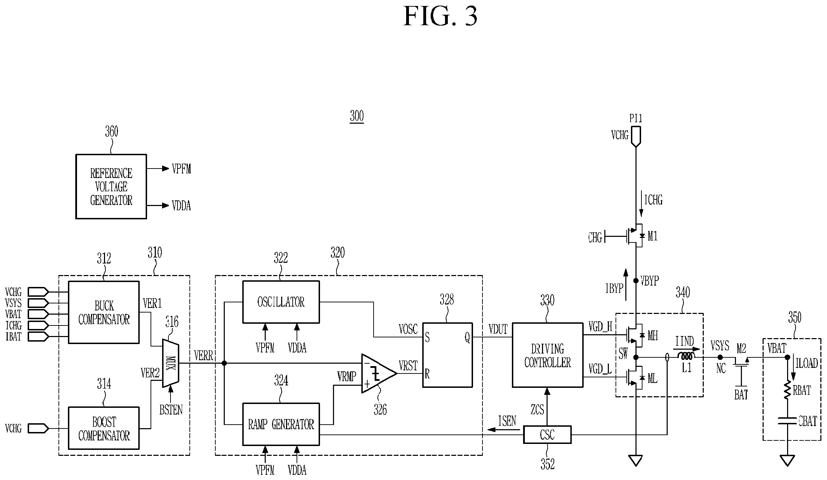

FIG. 3 illustrates a detailed block diagram of a voltage converter according to an embodiment.

A voltage converter 300 may include an error voltage generator 310, a duty signal generator 320, a driving controller 330, and a switch circuit 340. In addition, the voltage converter 300 may include a current sensing circuit 352 and a reference voltage generator 360.

The error voltage generator 310 may generate an error voltage VERR. The error voltage generator 310 may generate an error voltage for operating the switch circuit 340 as a buck converter, or may generate an error voltage for operating it as a boost converter. The error voltage generator 310 may include a buck compensator 312, a boost compensator 314, and a selector 316, which may be a multiplexer (MUX).

The buck compensator 312 may convert an input voltage VCHG to generate a first error voltage VER1 for generating a system voltage VSYS that is lower than the input voltage VCHG. The buck compensator 312 may generate the first error voltage VER1 based on control factors such as a bypass voltage VBYP, the system voltage VSYS, a battery voltage VBAT, a charging current ICHG, a battery current IBAT, and the like. The buck compensator 312 may generate the first error voltage VER1 based on a control factor that is closest to a reference value among several control factors.

The boost compensator 314 may generate a second error voltage VER2. The battery voltage VBAT may be converted by the second error voltage VER2 to generate the charging voltage VCHG that is higher than the battery voltage VBAT. The boost compensator 314 may generate the second error voltage VER2 based on a control factor such as the charging voltage VCHG. The boost compensator 314 may generate the second error voltage VER2 by comparing the charging voltage VCHG with a reference value.

The selector 316 may be connected to the buck compensator 312 and the boost compensator 314. The first error voltage VER1 outputted from the buck compensator 312 and the second error voltage VER2 outputted from the boost compensator 314 may be applied to two input terminals of the selector 316, respectively. The selector 316 may output the voltage VER1 or VER2 provided to one of the two input terminals as the error voltage VERR based on a control signal BSTEN.

The duty signal generator 320 may generate a duty signal VDUT by using the provided error voltage VERR and a reference voltage VPFM, and may output it. The duty signal generator 320 may include an oscillator 322, a ramp signal generator 324, a hysteresis comparator 326, and an R/S flip-flop 328.

The oscillator 322 may generate an oscillating signal VOSC having a period based on a difference between the error voltage VERR and the reference voltage VPFM. In an embodiment, when the error voltage VERR exceeds the reference voltage VPFM, the oscillator 322 may generate the oscillating signal VOSC by using a PWM method, and when the error voltage VERR is smaller than or equal to the reference voltage VPFM, the oscillator 322 may generate the oscillating signal VOSC by using a PFM method. When the PFM method is used, the oscillator 322 may determine the period of the oscillating signal VOSC based on the difference between the error voltage VERR and the reference voltage VPFM.

The ramp signal generator 324 may generate a ramp signal VRMP having a slope based on a value of the error voltage VERR. The ramp signal generator 324 may generate the ramp signal VRMP that linearly increases from an initial voltage level. The initial voltage level of the ramp signal VRMP may correspond to an amount of an inductor current IIND. In addition, the ramp signal generator 324 may generate the ramp signal VRMP having a smaller slope as the error voltage VERR increases. A power voltage VDDA may be applied to the oscillator 322 and the ramp signal generator 324.

The hysteresis comparator 326 may output a reset signal VRST by comparing the error voltage VERR with the ramp signal VRMP. When the voltage of the ramp signal VRMP is smaller than the error voltage VERR, the hysteresis comparator 326 may output the reset signal VRST having a logic low level. When the voltage of the ramp signal VRMP is equal to the error voltage VERR, the hysteresis comparator 326 may output the reset signal VRST having a logic high level. For example, until the ramp signal VRMP linearly increases to the level of the error voltage VERR, the reset signal VRST may have a logic low level, and when the ramp signal VRMP is equal to the level of the error voltage VERR, the reset signal VRST may have a logic high level. Accordingly, the reset signal VRST may have a pulse form.

The R/S flip-flop 328 may output the duty signal VDUT having a logic high level at an edge (for example, a rising edge that is changed from a logic low to a logic high) of an oscillating signal OSC, and may output the duty signal VDUT having a logic low level at an edge of the reset signal VRST.

The driving controller 330 may generate a first driving control signal VGD_H and a second driving control signal VGD_L based on the duty signal VDUT and a sensing signal ZCS. The driving controller 330 may generate the first driving control signal VGD_H having a logic high level and the second driving control signal VGD_L having a logic low level based on the duty signal VDUT having a logic high level. The driving controller 330 may generate the first driving control signal VGD_H having a logic low level and the second driving control signal VGD_L having a logic high level based on the duty signal VDUT having a logic low level. In some embodiments, the driving controller 330 may change the second driving control signal VGD_L having a logic high level to the second driving control signal VGD_L having a logic low level based on the sensing signal ZCS. For example, the sensing signal ZCS may indicate whether the inductor current IIND decreases to 0 or less, and is used to prevent the inductor current IIND from flowing from the battery 350 to the ground.

The switch circuit 340 may include a first driving element MH connected between one terminal of a first transistor M1 and a switching node SW and including a control terminal receiving the first driving control signal VGD_H, and a second driving element ML connected between the switching node SW and the ground voltage and including a control terminal receiving the second driving control signal VGD_L. The switch circuit 340 may store energy in an inductor L1 by a current flowing from the input power voltage VCHG to the inductor L1 through the switching node SW in response to the first driving control signal VGD_H having the logic high level, and may discharge the energy stored in the inductor L1 in response to the second driving control signal VGD_L having the logic high level. In FIG. 3, both the first driving element MH and the second driving element ML are illustrated as N-type transistors, however embodiments are not limited thereto. For example, in embodiments both of the first driving element MH and the second driving element ML may be P-type transistors, and in embodiments one of the first driving element MH and the second driving element ML may be an N-type transistor and the other thereof may be a P-type transistor.

When the first driving element MH is turned on, or activated, in response to the first driving control signal VGD_H having the logic high level and the second driving element ML is turned off, or deactivated, in response to the second driving control signal VGD_L having the logic low level, the input voltage VCHG is applied to the switching node SW, and the inductor current IIND flows toward the second transistor M2 through the inductor L1. When the first driving element MH is turned off in response to the first driving control signal VGD_H having the logic low level and the second driving element ML is turned on in response to the second driving control signal VGD_L having the logic high level, the inductor current IIND flows through the inductor L1 and the second driving element ML, and an amount of the inductor current IIND gradually decreases.

The current sensing circuit 352 may sense the inductor current IIND to generate a sensing current ISEN, and may output the sensing signal ZCS representing a zero-current level of the inductor current IIND based on the sensing current ISEN. The sensing current ISEN is a current generated by sensing the inductor current IIND, and may be a current which is controlled according to the amount of the inductor current IIND. The sensing signal ZCS may be a voltage signal.

The first transistor M1 has a source connected to the input/output pin PI1, a drain connected to a terminal of the first driving element MH and a gate controlled by the control signal CHG.

The second transistor M2 may transmit a system voltage VSYS of a charging node NC to the battery 350 in response to a control signal BAT.

The battery 350 may pass a load current ILOAD through a resistor RBAT and to a capacitor CBAT, for storage, the capacitor CBAT being connected in series between the resistor RBAT and ground voltage.

The reference voltage generator 360 may generate the reference voltage VPFM and the power voltage VDDA.

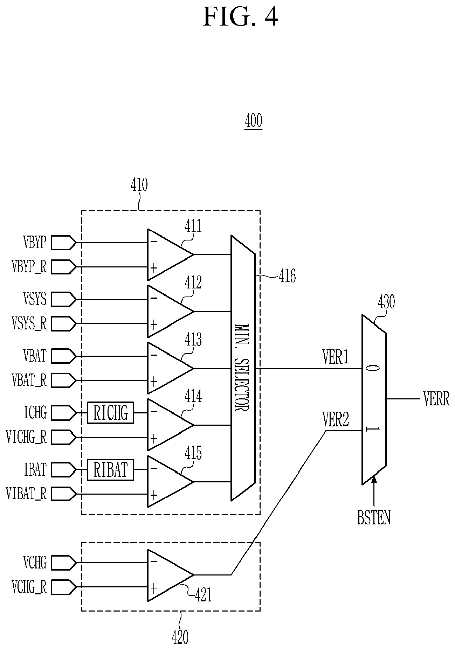

Examples of the error voltage generator 310 and the duty signal generator 320 are described with reference to FIG. 4, FIG.5, and FIG. 6.

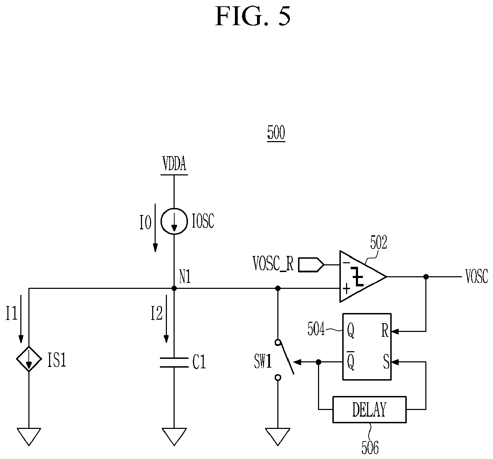

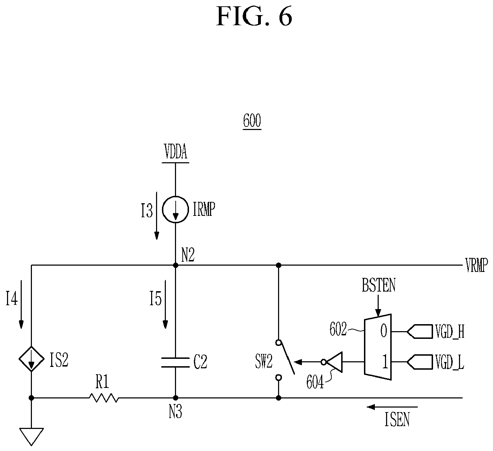

FIG. 4 illustrates a detailed circuit diagram of an error voltage generator according to an embodiment, FIG. 5 illustrates a detailed circuit diagram of an oscillator according to an embodiment, and FIG. 6 illustrates a detailed circuit diagram of a ramp generator according to an embodiment.

Referring to FIG. 4, an error voltage generator 400 may include a buck compensator 410, a boost compensator 420, and a selector 430. The buck compensator 410 may include a plurality of comparators 411, 412, 413, 414, and 415 and a minimum value selector 416.

The plurality of comparators 411, 412, 413, 414, and 415 may respectively receive corresponding control factors VBYP, VSYS, VBAT, ICHG, and IBAT and corresponding reference voltages VBYP_R, VSYS_R, VBAT_R, VICHG_R, and VIBAT_R, and may output differences between the two respective signals. In some embodiments, among the plurality of comparators 411, 412, 413, 414, and 415, the comparators 414 and 415 that receive the currents ICHG and IBAT have input terminals that may receive voltages through resistors RICHG and RIBAT, respectively.

The minimum value selector 416 may include input terminals connected to output terminals of the plurality of comparators 411, 412, 413, 414, and 415 and an output terminal connected to an input terminal of the selector 430. In an embodiment, the minimum value selector 416 may select the smallest value among voltages respectively outputted from the comparators 411, 412, 413, 414, and 415 to output it as a first error voltage VER1.

The boost compensator 420 may also include a comparator 421. The comparator 421 may receive a charging voltage VCHG and a reference voltage VCHG_R, and may output a difference between the two signals as a second error voltage VER2.

The selector 430 may include a first input terminal connected to the output terminal of the minimum value selector 416 and a second input terminal connected to the output terminal of the comparator 421. A control signal BSTEN may be applied to a control terminal of the selector 430. The selector 430 may output the voltage VER1 or VER2 provided to one of the first input terminal and the second input terminal as an error voltage VERR based on the control signal BSTEN.

Referring to FIG. 5, an oscillator 500 may include a current source IOSC, a dependent current source IS1, a capacitor C1, a hysteresis comparator 502, an R/S flip-flop 504, a delay 506, and a switching element SW1.

The current source IOSC may be connected between a power voltage VDDA and a first node N1. The dependent current source IS1 may be connected between the first node N1 and a ground voltage. A current I1 according to the dependent current source IS1 may be determined by the following Equation 1.

(Equation 1)

$$I1 = G1(VPFM- VERR), \ IF \ VERR \leq VPFM$$

$$I1 = 0, \ IF \ VERR > VPFM$$

The capacitor C1 may be connected between the first node N1 and the ground voltage. The capacitor C1 may be charged with a current I2 of a current I0 of the current source IOSC excluding the current I1 of the dependent current source IS1. As the capacitor C1 is charged, a voltage of the first node N1 may increase. A slope of the voltage charged in the capacitor C1 may be represented by Equation 2 below.

(Equation 2)

$$SLOPE\_OSC = I2/C1$$

Here, SLOPE_OSC denotes a slope of the voltage charged in the capacitor C1, and C1 denotes a capacitance of the capacitor C1.

The hysteresis comparator 502 may include a first input terminal that receives an oscillating reference voltage VOSC_R, a second input terminal connected to the first node N1, and an output terminal that outputs an oscillating signal VOSC. The hysteresis comparator 502 may output the oscillating signal VOSC of a logic low level until the voltage of the first node N1 reaches the oscillating reference voltage VOSC_R. The hysteresis comparator 502 may output the oscillating signal VOSC having a logic high level when the voltage of the first node N1 reaches the oscillating reference voltage VOSC_R.

A first input terminal (R) of the R/S flip-flop 504 may be connected to the output terminal of the hysteresis comparator 502, a second input terminal (S) of the R/S flip-flop 504 may be connected to an output terminal of the delay 506, and an output terminal ($\overline{Q}$) of the R/S flip-flop 504 may be connected to a control terminal of the switching element SW1. An input terminal of delay 506 may be connected to the output terminal of the R/S flip-flop 504. The switching element SW1 may be connected between the first node N1 and the ground voltage.

In an embodiment, when the oscillating signal VOSC is changed to a logic high level, the R/S flip-flop 504 may output a control signal having a logic low level. When the output signal having the logic low level is delayed by the delay 506 to be provided to the second input terminal of the R/S flip-flop 504, the R/S flip-flop 504 may output a control signal having a logic high level. Then, the switching element SW1 may be turned on, and may electrically connect the first node N1 and the ground voltage. Because the capacitor C1 is discharged by the ground voltage, the voltage of the first node N1 may decrease. Due to the decreased voltage of the first node N1, the hysteresis comparator 502 may output the oscillating signal VOSC having a logic low level.

For example, the oscillator 500 may compare the voltage charged in the capacitor C1 by the current I2 determined based on the error voltage VERR and the oscillating reference voltage VOSC_R to adjust a period of the output signal VOSC. As the error voltage VERR increases, for example when the control factor does not approach the reference value, the period of the output signal VOSC may be decreased, and as the error voltage VERR decreases, for example when the control factor approaches the reference value, the period of the output signal VOSC may be increased.

Referring to FIG. 6, a ramp signal generator 600 may include a current source IRMP, a dependent current source IS2, a capacitor C2, a resistor R1, a selector 602, an inverter 604, and a switching element SW2.

The current source IRMP may be connected between a power voltage VDDAand a second node N2. The dependent current source IS2 may be connected between the second node N2 and a ground voltage. A current I4 according to the dependent current source IS2 may be determined by the following Equation 3.

(Equation 3)

$$I4 = G2(VPFM- VERR), \ IF \ VERR \leq VPFM$$

$$I4 = 0, \ IF \ VERR > VPFM$$

The capacitor C2 may be connected between the second node N2 and a third node N3. The capacitor C2 may be charged with a current I5, which may be obtained by excluding the current I4 from a current I3 of the current source IRMP. As the capacitor C2 is charged, a voltage of the second node N2 may increase. A slope of the voltage charged in the capacitor C2 may be represented by Equation 4 below.

(Equation 4)

$$SLOPE\_RAMP = I5/C2$$

Here, SLOPE_RAMP denotes a slope of the voltage charged in the capacitor C2, and C2 denotes a capacitance of the capacitor C2.

A voltage VRMP outputted by the ramp signal generator 600 may be represented by Equation 5 below.

(Equation 5)

$$VRMP = VN3 + VC2$$

Here, VN3 denotes a voltage of the third node N3, and VC2 denotes a voltage charged in the capacitor C2.

The resistor R1 may be connected between the ground voltage and the third node N3. A sensing current ISEN may flow through the resistor R1. Accordingly, a voltage of the third node N3 may be represented by Equation 6 below.

(Equation 6)

$$VN3 = ISEN * R1$$

A first driving control signal VGD_H may be provided to a first input terminal of the selector 602, and a second driving control signal VGD_L may be provided to a second input terminal of the selector 602. The selector 602 may output the first driving control signal VGD_H or the second driving control signal VGD_L based on a control signal BSTEN. An output terminal of the selector 602 may be connected to an input terminal of the inverter 604. An output terminal of the inverter 604 may be connected to a control terminal of the switching element SW2. The switching element SW2 may be connected between the second node N2 and the third node N3.

In an embodiment, by the duty signal VDUT transitioning to the logic high level, the selector 602 may output the first driving control signal VGD_H having the logic high level. The inverter 604 may invert the first driving control signal VGD_H having the logic high level to output a signal having a logic low level. Then, the switch SW2 may be turned off, so that the second capacitor C2 may be charged. As the second capacitor C2 is charged, the ramp signal VRMP may increase. When the ramp signal VRMP increases and becomes equal to the error voltage VERR, the duty signal VDUT may transition to a logic low level. By the duty signal VDUT transitioning to the logic low level, the level of the first driving control signal VGD_H may transition to a logic low level. When the control signal BSTEN is at a logic low level, the selector 602 may output the first driving control signal VGD_H having the logic low level. The inverter 604 may invert the first driving control signal VGD_H having the logic low level to output a signal having a logic high level. Then, the switch SW2 may be turned on, and may electrically connect the second node N2 and the third node N3. Because the capacitor C2 is discharged by the ground voltage through the resistor R1, the voltage of the second node N2 may be decreased. By the decreased voltage of the second node N2, the voltage of the third node N3 may be output as the ramp signal VRMP.

For example, the ramp signal generator 600 may output a voltage charged in the capacitor C2 by the current I5 determined based on the error voltage VERR as the ramp signal VRMP, and thus the ramp signal generator 600 may adjust a slope of the ramp signal VRMP. Because a time at which the ramp signal VRMP reaches the error voltage VERR is controlled by the adjusted slope, output timing of a reset signal VRST for resetting the duty signal VDUT may be adjusted. As the error voltage VERR increases, for example when the control factor is not close to the reference value, the slope of the ramp signal VRMP decreases and the output timing of the reset signal VRST is delayed, so that an on-duty period of the duty signal VDUT may increase. As the error voltage VERR decreases, for example when the control factor is close to the reference value, the slope of the ramp signal VRMP increases and the output timing of the reset signal VRST becomes faster, so that the on-duty period of the duty signal VDUT may decrease.

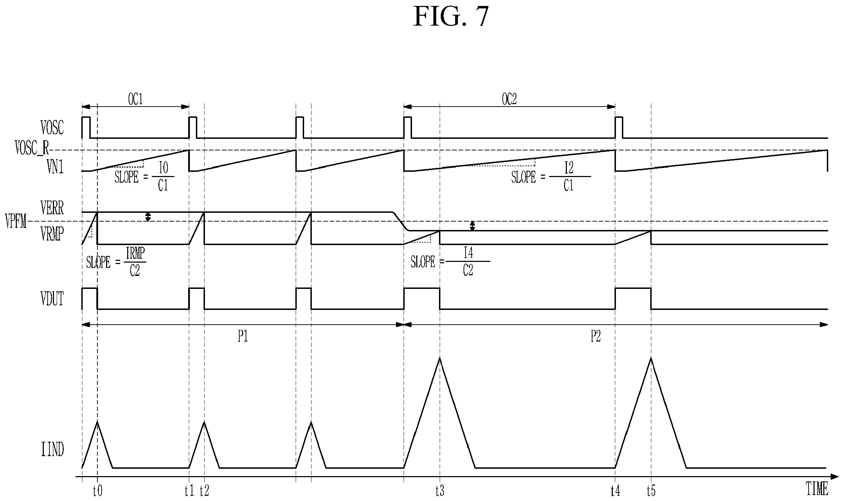

FIG. 7 illustrates a timing diagram of several signals of a voltage supply device according to an embodiment.

Referring to FIG. 7, a period P1 is a period in which the error voltage VERR is greater than the reference voltage VPFM, and the voltage converter 300 may be operated by the PWM method in the period P1.

When the error voltage VERR is greater than the reference voltage VPFM, the current I1 of the dependent current source IS1 of the oscillator 500 is 0 by Equation 1, so the capacitor C1 may be charged with the current I0 of the current source IOSC. A slope of the voltage charged in the capacitor C1 may be represented by Equation 7 below.

$$\text{(Equation 7)}$$

$$\text{SLOPE\_OSC\_PWM} = \text{I0/C1}$$

During a period from t0 when the R/S flip-flop (for example R/S flip-flop 328 of FIG. 3) is reset to t1 before the voltage VN1 of the first node N1 reaches the oscillating reference voltage VOSC_R, the hysteresis comparator 502 may output the oscillating signal VOSC having the logic low level. At t1 when the voltage of the first node N1 reaches the oscillating reference voltage VOSC_R, the hysteresis comparator 502 may output the oscillating signal VOSC having the logic high level. Then, the R/S flip-flop 328 may output the duty signal VDUT having the logic high level.

When the error voltage VERR is greater than the reference voltage VPFM, the current I4 of the dependent current source IS2 of the ramp signal generator (600 in FIG. 6) is 0 by Equation 3, so the capacitor C2 may be charged with the current I3 of the current source IRMP. A slope of the voltage charged in the capacitor C2 may be represented by Equation 8 below.

$$\text{(Equation 8)}$$

$$\text{SLOPE\_RAMP\_PWM} = \text{I3/C2}$$

By the duty signal VDUT transitioning to the logic high level, at t1, the selector 602 may output the first driving control signal VGD_H having the logic high level. Then, the switch SW2 is turned off, so that the second capacitor C2 may be charged. As the second capacitor C2 is charged, the ramp signal VRMP may increase. When the ramp signal VRMP increases and becomes equal to the error voltage VERR at t2, the duty signal VDUT may transition to the logic low level. By the duty signal VDUT transitioning to the logic low level, the level of the first driving control signal VGD_H may transition to the logic low level. When the control signal BSTEN is at the logic low level, the ramp signal VRMP may be initialized to a voltage (ISEN*R1) of the third node N3 by the first driving control signal VGD_H transitioning to the logic low level.

In an embodiment, when the error voltage VERR is greater than the reference voltage VPFM, it may be controlled by the PWM method based on the error voltage VERR. The period of the duty signal VDUT may follow the period OC1 of the oscillating signal VOSC. The oscillating signal VOSC is determined by whether the voltage VN1 of the first node N1 reaches the oscillating reference voltage VOSC_R, and the slope at which the voltage VN1 of the first node N1 increases is dependent on the current I0 of the current source IOSC, so that the period of the duty signal VDUT may be related to the current source IOSC. The duty cycle of the duty signal VDUT may be controlled by a difference between the error voltage VERR and the ramp signal VRMP. The reset signal VRST that resets the R/S flip-flop 328 may be output by comparing the error voltage VERR with the ramp signal VRMP. The slope at which the ramp signal VRMP increases may be fixed depending on the current I3 of the current source IRMP, while the error voltage VERR may vary, so the output timing of the reset signal VRST may be controlled by the error voltage VERR. Accordingly, the duty cycle of the duty signal VDUT may be controlled by the error voltage VERR.

A period P2 is a period in which the error voltage VERR is equal to or smaller than the reference voltage VPFM, and in the period P2, the voltage converter 300 may operate the duty cycle in a duty-controlled PFM (D-PFM) method.

When the error voltage VERR is equal to or smaller than the reference voltage VPFM, the current I2 of the dependent current source IS1 of the oscillator 500 is G1 (VPFM-VERR) by Equation 1, so that the capacitor C1 may be charged with the current I2 excluding the current I1 of the dependent current source IS1 from the current I0 of the current source IOSC. The slope of the voltage charged in the capacitor C1 is represented by Equation 2.

During a period from t3 when the R/S flip-flop 328 is reset to t4 before the voltage VN1 of the first node N1 reaches the oscillating reference voltage VOSC_R, the hysteresis comparator 502 may output the oscillating signal VOSC having the logic low level. At t4 when the voltage of the first node N1 reaches the oscillating reference voltage VOSC_R, the hysteresis comparator 502 may output the oscillating signal VOSC having the logic high level. Then, the R/S flip-flop 328 may output the duty signal VDUT having the logic high level.

When the error voltage VERR is equal to or smaller than the reference voltage VPFM, the current I4 of the dependent current source IS2 of the ramp signal generator 600 is G2 (VPFM-VERR) by Equation 3, so that the capacitor C2 may be charged with the current I5 excluding the current I4 of the dependent current source IS2 from the current I3 of the current source IRMP. The slope of the voltage charged in the capacitor C2 is represented by Equation 4.

By the duty signal VDUT transitioning to the logic high level, at t4, the selector 602 may output the first driving control signal VGD_H having the logic high level. Then, the switch SW2 may be turned off, so that the second capacitor C2 may be charged. As the second capacitor C2 is charged, the ramp signal VRMP may increase. When the ramp signal VRMP increases and becomes equal to the error voltage VERR at t5, the duty signal VDUT may transition to the logic low level. By the duty signal VDUT transitioning to the logic low level, the level of the first driving control signal VGD_H may transition to the logic low level. When the control signal BSTEN is at the logic low level, the ramp signal VRMP may be initialized to a voltage (ISEN*R1) of the third node N3 by the first driving control signal VGD_H transitioning to the logic low level.

In an embodiment, when the error voltage VERR is smaller than or equal to the reference voltage VPFM, it may be controlled by the D-PFM method based on the error voltage VERR. The period of the duty signal VDUT may follow the period OC2 of the oscillating signal VOSC. The oscillating signal VOSC is determined by whether the voltage VN1 of the first node N1 reaches the oscillating reference voltage VOSC_R, and the slope at which the voltage VN1 of the first node N1 increases is related to the current I0 of the current source IOSC as well as the current I1 of the dependent current source IS1 based on the error voltage VERR, so that the period of the duty signal VDUT may be changed by the error voltage VERR. For example, the period of the duty signal VDUT is changed by the error voltage VERR, so that the operation of the PFM method may be performed. The duty cycle of the duty signal VDUT may be controlled by a difference between the error voltage VERR and the ramp signal VRMP. The reset signal VRST that resets the R/S flip-flop 328 may be outputted by comparing the error voltage VERR with the ramp signal VRMP. Because the slope at which the ramp signal VRMP increases is related to the current I3 of the current source IRMP as well as the current I4 of the dependent current source IS2 based on the error voltage VERR, the duty cycle of the duty signal VDUT may be changed by the error voltage VERR. Because both of the error voltage VERR and the ramp signal VRMP are related to the error voltage VERR, the output timing of the reset signal VRST may be controlled by the error voltage VERR. However, compared to the PWM method, since the slope of the ramp signal VRMP is decreased by the error voltage VERR, the duty cycle may increase. Accordingly, compared to a PWM method in which the slope of the ramp signal VRMP is fixed, the feedback error voltage VERR is decreased, so that the period cycle of the duty signal VDUT may be longer.

As in Equation 9, efficiency loss $P_{LOSS}$ may be classified into conduction loss caused by on-resistance $R_{ON}$ of the charging integrated circuit 130 and switching loss caused by node conversion of the charging integrated circuit 130.

## (Equation 9)

$$P_{LOSS} = I^2 \cdot R_{ON} + f_{sw} \cdot C \cdot VSYS^2$$

Here, $P_{LOSS}$ denotes efficiency loss, I denotes a current, $R_{ON}$ denotes on-resistance between the charger 110 and the charging integrated circuit 130, C denotes capacitance between the charger 110 and the charging integrated circuit 130, $f_{sw}$ denotes a switching frequency, and VSYS denotes a voltage of the switching node SW. Under the light load condition, the current I is small, so that the effect of the switching loss is greater than that of the conduction loss.

According to the embodiment, because the period and duty cycle of the duty signal VDUT increase compared to the phase shift keying (PSK) method and the FWM method under the light load condition, the switching frequency $f_{sw}$ may be decreased, so that the switching loss may be reduced.

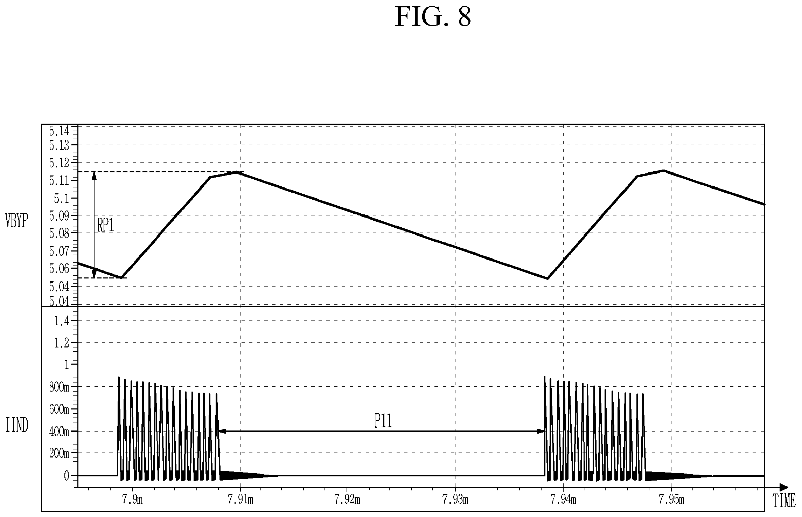

FIG. 8, FIG. 9, and FIG. 10 illustrate waveform diagrams of an inductor current and an output voltage of a voltage converter according to an embodiment.

FIG. 8 shows a bypass voltage VBYP and an inductor current IIND while using the PSK method under the light load condition. The switch circuit 340 performs a focused switching operation such as a burst operation within a short period, and after the switching operation is terminated, a period P11 until the next switching operation starts is relatively long. For example, because the bypass voltage VBYP falls during the period P11 and then rises according to the burst operation, the bypass voltage VBYP may have a relatively large ripple voltage RP1.

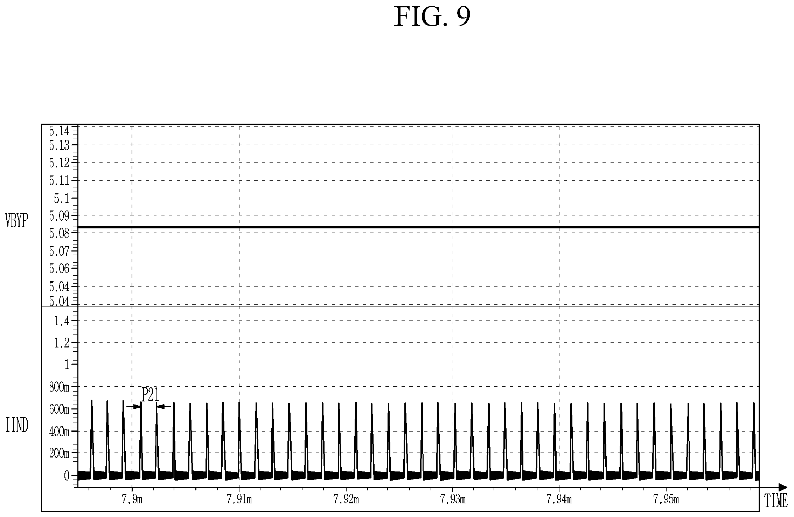

FIG. 9 shows an example of the bypass voltage VBYP and the inductor current IIND while adjusting the period of the oscillating signal VOSC of the oscillator 500 based on the error voltage VERR, without changing the slope of the ramp signal VRMP under the light load condition. Because the switch circuit 340 operates according to a certain period P21, the ripple of the bypass voltage VBYP may be reduced compared to FIG. 8, but because the number of switching operations is similar to the number of switching operations of FIG. 8, it may be difficult to reduce the switching loss.

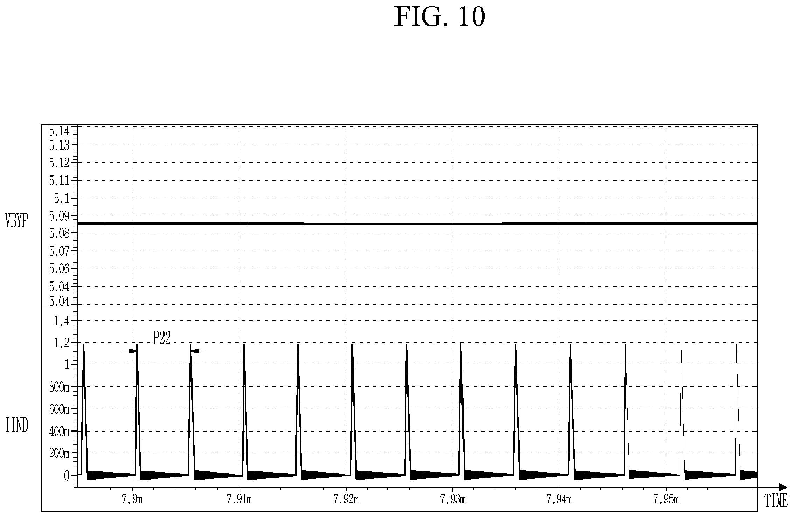

FIG. 10, shows an example of the bypass voltage VBYP and the inductor current IIND while adjusting the period of the oscillating signal VOSC of the oscillator 500 based on the error voltage VERR and changing the slope of the ramp signal VRMP under the light load condition. Compared to FIG. 8, because the switch circuit 340 operates according to a certain period P22, the ripple of the bypass voltage VBYP may be reduced. In addition, compared to FIG. 8 and FIG. 9, as the duty cycle of the duty signal increases, the period in which the inductor current IIND flows according to one switching operation and the amount of the inductor current IIND also increase, so that, because the number of switching operations is smaller than the number of switching operations in FIG. 8 and FIG. 9, the switching loss may also be improved.

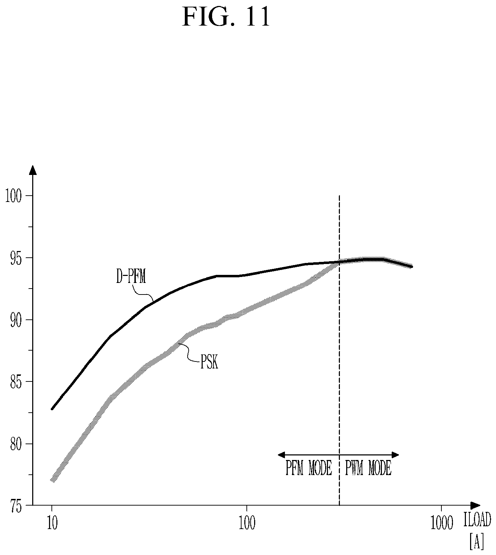

FIG. 11 illustrates a graph of efficiency of a voltage converter according to an embodiment.

Referring to FIG. 11, the efficiency according to the load current ILOAD is shown. Under the light load condition in which the PFM method is used, the efficiency of the D-PFM method is higher than that of the PSK method at the same load current ILOAD. Therefore, according to the D-PFM method, it is possible to increase the efficiency of power transmitted to a load.

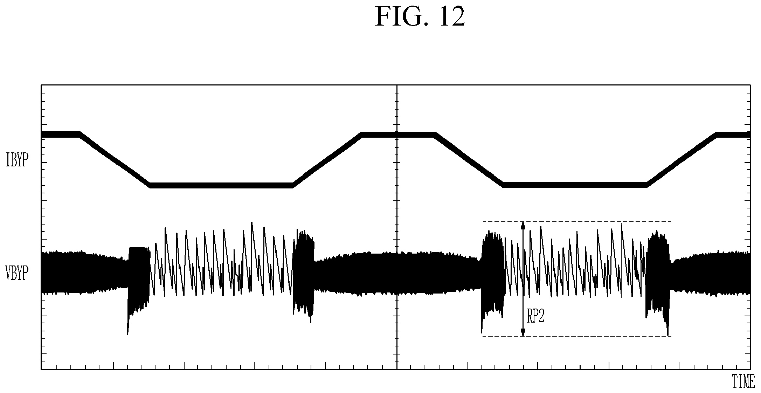

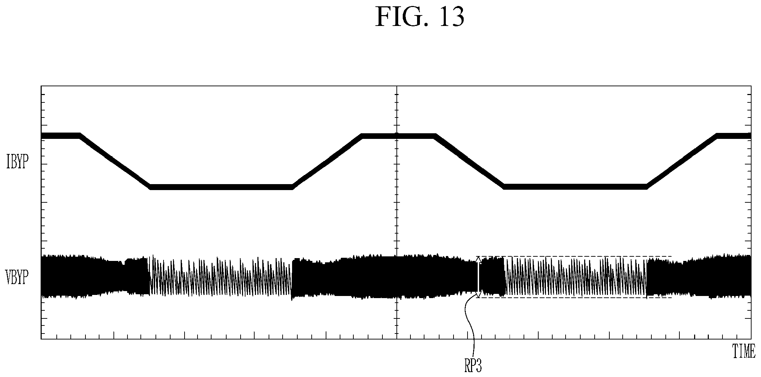

FIG. 12 and FIG. 13 illustrate waveform diagrams of an output current and an output voltage of a voltage converter according to an embodiment.

Referring to FIGS. 12 and FIG. 13, an example of the bypass voltage VBYP is shown when the bypass current IBYP is adjusted within a predetermined range according to time in the PSK method and the D-PFM method, respectively. Under the light load condition where the bypass current IBYP is small, the ripple voltage RP3 of the bypass voltage VBYP when the D-PFM method is used is smaller than the ripple voltage RP2 of the bypass voltage VBYP when the PSK method is used. Therefore, according to embodiments, it is possible to provide a stable DC output voltage with little ripple.

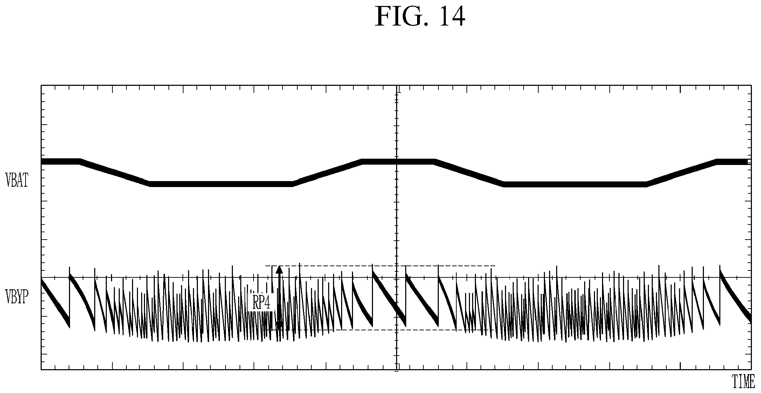

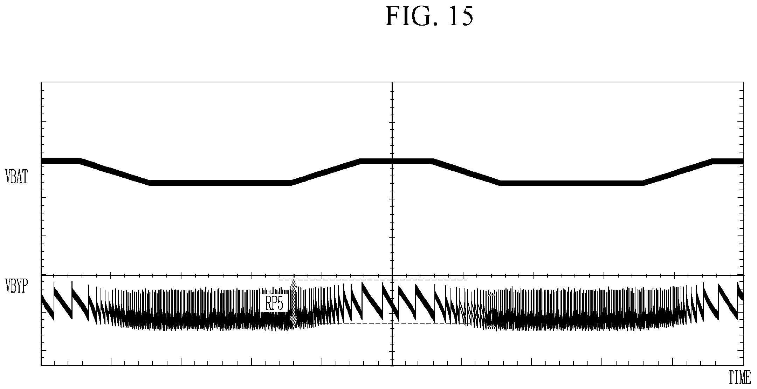

FIG. 14 and FIG. 15 illustrate waveform diagrams of an input voltage and an output voltage of a voltage converter according to an embodiment.

Referring to FIG. 14 and FIG. 15, the bypass voltage VBYP is shown when the battery voltage VBAT is adjusted within a predetermined range according to time in the PSK method and the D-PFM method, respectively. Under the condition in which the battery voltage VBAT used as the input voltage is large, the ripple voltage RP5 of the bypass voltage VBYP when the D-PFM method is used is smaller than the ripple voltage RP4 of the bypass voltage VBYP when the PSK method is used. Therefore, according to embodiments, it is possible to provide a stable DC output voltage with little ripple.

In addition, because both of the D-PFM method and the PWM method use the voltage VOSC having a constant period, it may be easier to change the operation between the D-PFM method and the PWM method than to change the operation between the PSK method and the PWM method.

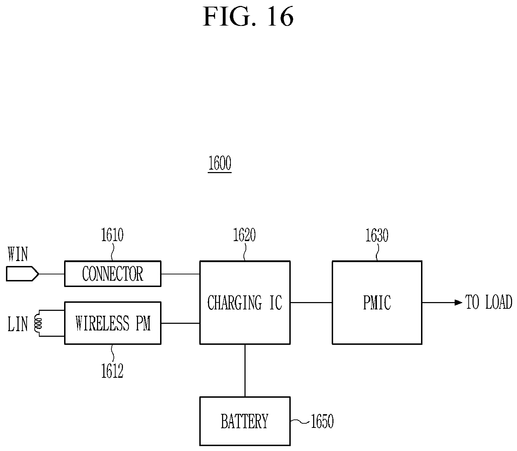

FIG. 16 illustrates a block diagram of a power system of a mobile device according to an embodiment.

Referring to FIG. 16, a power system 1600 may include a connector 1610, a wireless power manager 1612 (illustrated as "WIRELESS PM"), a charging integrated circuit 1620 (illustrated as "CHARGING IC"), a battery 1650, and a power management integrated circuit (PMIC) 1630. The power system 1600 shown in FIG. 16 may further include elements not shown in FIG. 16. Alternatively, the power system 1600 may not include one or more of elements shown in FIG. 16.

The power system 1600 may be used to supply power to a mobile device. The power system 1600 may receive power from a power source connected by wire through a conversion device such as an adapter. Alternatively, the power system 1600 may be supplied with power from a power source connected wirelessly by resonance of an inductor. The power system 1600 may properly convert the supplied power. The power system 1600 may supply the converted power to elements included in a mobile electronic device.

For example, the connector 1610 may be connected to a conversion device such as a charger through a wired input terminal WIN. The connector 1610 may receive power from a power source connected by wire. The connector 1610 may appropriately convert the supplied power, and may provide the converted power to the charging integrated circuit 1620.

For example, the wireless power manager 1612 may be connected to an input inductor LIN. The input inductor LIN may resonate with a transmission inductor of a wireless power transmitter. The wireless power manager 1612 may receive power from a power source connected wirelessly by resonance between the input inductor LIN and the transmission inductor. The wireless power manager 1612 may appropriately convert the received power, and may provide the converted power to the charging integrated circuit 1620.

The charging integrated circuit 1620 may operate in one of a battery power mode (BPM), a charging mode (CM), and a boost mode (BM). For example, when power is not supplied through the connector 1610 and the wireless power manager 1612, the charging integrated circuit 1620 may operate in the battery power mode. In the battery power mode, the charging integrated circuit 1620 may receive power from the battery 1650. The charging integrated circuit 1620 may appropriately convert the power provided from the battery 1650, and may provide the converted power to the PMIC 1630.

The charging integrated circuit 1620 may receive power from at least one of the connector 1610, the wireless power manager 1612, and the battery 1620. The charging integrated circuit 1620 may appropriately convert the received power. For example, the charging integrated circuit 1620 may charge the battery 1650 by using the converted power. The charging integrated circuit 1620 may provide the converted power to the PMIC 1630. The charging integrated circuit 1620 may provide the converted power to the OTG device connected to the connector 1610. In an embodiment, the charging integrated circuit 1620 may adjust the period and the duty cycle of the duty signal, which is the basis of a switching operation for power conversion, by using the D-PFM method under the light load condition. The configuration and operations of the charging integrated circuit 1620 according to the embodiment may be as described in FIG. 1 to FIG. 7.

The PMIC 1630 may receive power from the charging integrated circuit 1620. For example, the PMIC 1630 may convert a voltage provided from the charging integrated circuit 1620 into a stable voltage. The PMIC 1630 may provide the stable voltage to other elements included in the mobile electronic device.

For example, each of the wireless power manager 1612, the charging integrated circuit 1620, and the PMIC 1630 may be implemented with an IC chip. Each of the wireless power manager 1612, the charging integrated circuit 1620, and the PMIC 1630 may be mounted by using various types of semiconductor packages. For example, each of the wireless power manager 1612, the charging integrated circuit 1620, and the PMIC 1630 may be mounted by using a package such as package on package (PoP), ball grid arrays (BGAs), chip scale packages (CSPs), plastic leaded chip carrier (PLCC), plastic dual in-line package (PDIP), die in waffle pack, die in wafer form, chip on board (COB), ceramic dual in-line package (CERDIP), metric quad flat pack (MQFP), thin quad flat pack (TQFP), small outline integrated circuit (SOIC), shrink small outline package (SSOP), thin small outline package (TSOP), system in package (SIP), multichip package (MCP), wafer-level fabricated package (WFP), or wafer-level processed stack package (WSP).

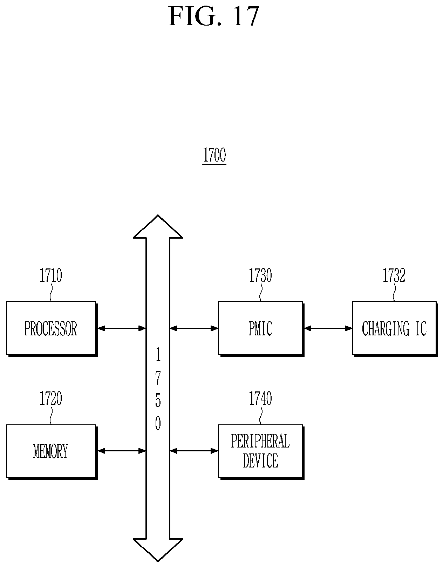

FIG. 17 illustrates a block diagram of a mobile device according to an embodiment.

Referring to FIG. 17, a mobile device 1700 according to an embodiment may include a processor 1710, a memory 1720, a PMIC 1730, a charging integrated circuit 1732 (illustrated as "CHARGING IC"), and a peripheral device 1740 that are electrically connected to a system bus 1750.

The processor 1710 may control input and output of data of the memory 1720, the PMIC 1730, the charging integrated circuit 1732, and the peripheral device 1740.

The memory 1720 may include a volatile memory such as a dynamic random access memory (DRAM) and/or a non-volatile memory such as a flash memory. The memory 1720 may be configured with a DRAM, a phase-change random access memory (PRAM), a magnetic random access memory (MRAM), a resistive random access memory (ReRAM), a ferroelectric random access memory (FRAM), a NOR flash memory, a NAND flash memory, and a fusion flash memory (for example, a memory in which a static random access memory (SRAM) buffer, a NAND flash memory, and a NOR interface logic are combined). The memory 1720 may store, for example, image data obtained from the peripheral device 1740 or an image signal processed by the processor 1710.

The PMIC 1730 may manage power used for an operation of the mobile device 1700.

The charging integrated circuit 1732 may be implemented according to the embodiments of the present invention described with reference to FIG. 1 to 7. The charging integrated circuit 1732 may include one or more charging paths. The charging integrated circuit 1732 may adjust the period and the duty cycle of the duty signal, which is the basis of a switching operation for power conversion, by using the D-PFM method under the light load condition. The configuration and operations of the charging integrated circuit 1732 according to the embodiment may be as described in FIG. 1 to FIG. 7. Descriptions of embodiments of the present invention are omitted for better understanding and ease of description.

The peripheral device 1740 may be a device that converts a moving image or a still image captured by a camera, a scanner, or a webcam into an electrical signal. Image data obtained through the peripheral device 1740 may be stored in the memory 1720, or may be displayed on a display of the mobile device 1700 in real time.

The mobile device 1700 may be a mobile electronic product such as a smartphone, but is not limited thereto, and may be various electronic products that display an image.

In some embodiments, each element or a combination of two or more elements described with reference to FIG. 1 to FIG. 17 may be implemented as a digital circuit, a programmable or non-programmable logic device or array, an application specific integrated circuit (ASIC), or the like.

Although specific embodiments have been described, it is to be understood that the disclosure is not limited to these specific embodiments, and is intended to cover various modifications and equivalent arrangements included within the scope of the appended claims.

**Claims**

1. A voltage converter comprising:

   a switch circuit configured to generate an output voltage by switching an input voltage and a ground voltage based on a driving control signal;
   an error voltage generator configured to generate an error voltage based on a comparison between the output voltage and a reference voltage;
   a duty signal generator configured to generate a duty signal having a constant pulse frequency or a modulated pulse frequency, based on a result of the comparing; and
   a driving controller configured to generate the driving control signal based on the duty signal.

2. The voltage converter of claim 1, wherein based on the error voltage being greater than the reference voltage, the duty signal generator is further configured to generate the duty signal having the constant pulse frequency, and to change a duty cycle of the duty signal.

3. The voltage converter of claim 1 or claim 2, wherein based on the error voltage being less than or equal to the reference voltage, the duty signal generator is further configured to generate the duty signal having the modulated pulse frequency, and to change a duty cycle of the duty signal.

4. The voltage converter of any preceding claim, wherein the duty signal generator comprises:

   an oscillator configured to generate an oscillating signal having a period which is based on a difference between the error voltage and the reference voltage;
   a ramp signal generator configured to generate a ramp signal having a slope which is based on a value of the error voltage;
   a first hysteresis comparator configured to compare the error voltage and the ramp signal to output a reset signal; and
   an R/S flip-flop comprising a first input terminal configured to receive the oscillating signal, a second input terminal configured to receive the reset signal, and an output terminal configured to output the duty signal having a logic high level at an edge of the oscillating signal, and to output the duty signal having a logic low level at an edge of the reset signal.

5. The voltage converter of claim 4, wherein the oscillator comprises:

   a current source connected between a power voltage and a node and configured to generate a first current;
   a dependent current source connected between the node and the ground voltage and configured to generate a second current based on the difference between the error voltage and the reference voltage;
   a capacitor connected between the node and the ground voltage; and
   a second hysteresis comparator comprising a first input terminal connected to the node, a second input terminal configured to receive an oscillating reference voltage, and an output terminal configured to output the oscillating signal.

6. The voltage converter of claim 5, wherein the dependent current source is further configured to generate the second current based on the error voltage being less than the reference voltage.

7. The voltage converter of any of claims 4 to 6, wherein the ramp signal generator comprises:

   a current source connected between a power voltage and a first node and configured to generate a first current;

a dependent current source connected between the first node and the ground voltage and configured to generate a second current based on the difference between the error voltage and the reference voltage;

a capacitor connected between the first node and a second node; and

a resistor connected between the second node and the ground voltage.

8. The voltage converter of claim 7, wherein the dependent current source is further configured to generate the second current based on the error voltage being less than the reference voltage.

9. The voltage converter of any preceding claim, wherein the driving control signal comprises a first driving control signal and a second driving control signal; and

wherein the switch circuit comprises:

a first driving element connected between a first node configured to receive the input voltage and a switching node, and comprising a control terminal configured to receive the first driving control signal;

a second driving element connected between the ground voltage and the switching node, and comprising a control terminal configured to receive the second driving control signal; and

an inductor connected between the switching node and the second node.

10. The voltage converter of claim 9, wherein based on the duty signal and the driving control signal transitioning to a logic high level, the driving controller is further configured to output the first driving control signal having the logic high level and to output the second driving control signal having a logic low level, and

wherein based on the duty signal and the driving control signal transitioning to the logic low level, the driving controller is further configured to output the first driving control signal having the logic low level and to output the second driving control signal having the logic high level.

11. The voltage converter of claim 9 or 10, further comprising

a current sensor configured to output a sensing signal representing a zero-current level of a current flowing in the inductor,

wherein the driving controller is further configured to change the second driving control signal to a logic low level based on the sensing signal.

12. The voltage converter of any of claims 9 to 11, wherein a ramp signal has an initial voltage level corresponding to an amount of current flowing through the inductor.

13. The voltage converter of any preceding claim, wherein the error voltage generator comprises:

a buck compensator configured to operate the switch circuit as a buck converter by generating a first error voltage based on the input voltage, an input current provided to the switch circuit, the output voltage, a battery voltage of a battery connected to the switch circuit, and a battery current flowing in the battery;

a boost compensator configured to operate the switch circuit as a boost converter by generating a second error voltage based on the output voltage; and

a selector configured to output the first error voltage or the second error voltage as the error voltage based on a control signal.

14. A power supply comprising:
a voltage converter of any preceding claim comprising:

a conversion circuit comprising a plurality of driving elements configured to convert an input voltage into an output voltage by switching based on a driving control signal, wherein the conversion circuit is configured to output the output voltage to a load; and

a charging controller configured to adjust a period of the driving control signal and a duty cycle of the driving control signal under a light load condition.

15. A power system comprising:
a voltage converter of any of claims 1 to 13:

wherein the switch circuit comprises:

a first driving element configured to connect a first node and a switching node based on a first driving control signal,

a second driving element configured to connect a ground voltage and the switching node based on a second driving control signal, and

an inductor connected between the switching node and a second node; and

wherein the voltage converter comprises a charging controller configured to:

generate the error voltage based on a smaller of a difference between a voltage of the first node and a first reference voltage, and a difference between a voltage of the switching node and a second reference voltage,

decrease a period of the first driving control signal and a period of the second driving control signal based on the error voltage increasing, and

increase a duty cycle of the first driving control signal and a duty cycle of the second driving control signal based on the error voltage increasing.

# FIG. 1

100

# FIG. 2

EP 4 362 301 A1

# FIG. 3

# FIG. 4

400

VBYP —▷
VBYP_R —▷ 411

VSYS —▷
VSYS_R —▷ 412

VBAT —▷
VBAT_R —▷ 413

ICHG —▷ RICHG
VICHG_R —▷ 414

IBAT —▷ RIBAT
VIBAT_R —▷ 415

MIN. SELECTOR 416

VCHG —▷
VCHG_R —▷ 421

410

420

VER1

VER2

430

VERR

BSTEN

0

1

# FIG. 5

# FIG. 6

# FIG. 7

EP 4 362 301 A1

# FIG. 8

EP 4 362 301 A1

EP 4 362 301 A1

# FIG. 9

FIG. 10

# FIG. 11

FIG. 12

FIG. 13

EP 4 362 301 A1

# FIG. 14

VBAT

VBYP

RP4

TIME

EP 4 362 301 A1

FIG. 15

# FIG. 16

1600

WIN ⊐  —  1610  CONNECTOR  —  1620  CHARGING IC  —  1630  PMIC  → TO LOAD

LIN ⊐  —  1612  WIRELESS PM

BATTERY ~ 1650

# FIG. 17

Europäisches
Patentamt

European
Patent Office

Office européen
des brevets

# EUROPEAN SEARCH REPORT

Application Number

EP 23 18 6079

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/322299 A1 (MICHISHITA YUUSUKE [JP] ET AL) 31 December 2009 (2009-12-31) * the whole document * * * in particular: * * paragraphs [0002], [0027] – [0029], [0034], [0064], [0076] – [0078], [0132]; figure 4 * | 1-15 | INV. H02M1/00 H02M3/158 ADD. H02M1/14 |
| X | WO 2014/038684 A1 (RICOH CO LTD [JP]; SHIWAYA YOHICHI [JP]) 13 March 2014 (2014-03-13) * paragraphs [0001], [0022], [0023], [0034], [0059]; figure 1 * | 1-15 | |
| X | US 2011/006744 A1 (DEARBORN SCOTT C [US]) 13 January 2011 (2011-01-13) * paragraphs [0004] – [0007], [0044]; figures 3,13 * * claim 1 * | 1-3 | |
| A | EP 1 533 902 A1 (POWER INTEGRATIONS INC [US]) 25 May 2005 (2005-05-25) * paragraphs [0016] – [0020]; figure 1A * | 5-8 | TECHNICAL FIELDS SEARCHED (IPC) H02M H03K |
| A | US 10 637 357 B1 (ZHAN XIAODONG [US] ET AL) 28 April 2020 (2020-04-28) * figure 3 * | 1-15 | |

The present search report has been drawn up for all claims

| Place of search | Date of completion of the search | Examiner |
|---|---|---|
| The Hague | 6 March 2024 | Standaert, Frans |

EPO FORM 1503 03.82 (P04C01)

## ANNEX TO THE EUROPEAN SEARCH REPORT
## ON EUROPEAN PATENT APPLICATION NO.

**EP 23 18 6079**

This annex lists the patent family members relating to the patent documents cited in the above-mentioned European search report.
The members are as contained in the European Patent Office EDP file on
The European Patent Office is in no way liable for these particulars which are merely given for the purpose of information.

**06-03-2024**

| Patent document cited in search report | | Publication date | Patent family member(s) | | Publication date |
|---|---|---|---|---|---|
| US 2009322299 | A1 | 31-12-2009 | JP | 5195182 B2 | 08-05-2013 |
| | | | JP | 2010063276 A | 18-03-2010 |
| | | | US | 2009322299 A1 | 31-12-2009 |
| WO 2014038684 | A1 | 13-03-2014 | CN | 104756384 A | 01-07-2015 |
| | | | EP | 2893627 A1 | 15-07-2015 |
| | | | JP | 2014050308 A | 17-03-2014 |
| | | | KR | 20150084783 A | 22-07-2015 |
| | | | US | 2015229212 A1 | 13-08-2015 |
| | | | WO | 2014038684 A1 | 13-03-2014 |
| US 2011006744 | A1 | 13-01-2011 | CN | 102449894 A | 09-05-2012 |
| | | | EP | 2452425 A2 | 16-05-2012 |
| | | | KR | 20120035911 A | 16-04-2012 |
| | | | TW | 201112593 A | 01-04-2011 |
| | | | US | 2011006744 A1 | 13-01-2011 |
| | | | WO | 2011005824 A2 | 13-01-2011 |
| EP 1533902 | A1 | 25-05-2005 | EP | 1533902 A1 | 25-05-2005 |
| | | | EP | 2043265 A1 | 01-04-2009 |
| | | | JP | 2005151528 A | 09-06-2005 |
| | | | US | 2005104672 A1 | 19-05-2005 |
| | | | US | 2006139111 A1 | 29-06-2006 |
| | | | US | 2008042763 A1 | 21-02-2008 |
| US 10637357 | B1 | 28-04-2020 | NONE | | |

EPO FORM P0459

For more details about this annex : see Official Journal of the European Patent Office, No. 12/82